# EUROPÄISCHE PATENTSCHRIFT

(11) **EP 3 812 131 B1**
(45) Veröffentlichungstag und Bekanntmachung des Hinweises auf die Patenterteilung: **13.04.2022**
(21) Anmeldenummer: 19204782.7
(22) Anmeldetag: 23.10.2019
(51) Int. Cl.: B29C 64/124, B29C 64/165, B33Y 10/00, B33Y 30/00, B29C 70/58

(54) **STEREOLITHOGRAPHIEVERFAHREN**
STEREOLITHOGRAPHY METHOD
PROCÉDÉ DE STÉRÉOLITHOGRAPHIE

(43) Veröffentlichungstag der Anmeldung: 28.04.2021
(73) Patentinhaber: Ivoclar Vivadent AG, 9494 Schaan (LI)
(72) Erfinder: HAGENBUCH, Konrad, 9469 Haag (CH); HAEFELE, Clemens Andreas, 6837 Weiler (AT); FREI, Roger, 9436 Balgach (CH)
(74) Vertreter: Splanemann, Rainer

(56) Entgegenhaltungen:
- WO-A2-2017/192859
- US-A1- 2014 085 620
- US-A1- 2018 200 948
- US-B2- 9 849 632
- US-B2- 10 392 521

## Beschreibung

Die vorliegende Erfindung betrifft ein Stereolithografieverfahren zum selektiven Aushärten einer Suspension die Füllstoffpartikel umfasst und eine Stereolithografievorrichtung für dieses Verfahren.

Die Druckschrift WO 2017/192859 A2 betrifft ein Verfahren zum kontinuierlichen Bilden eines dreidimensionalen Körpers aus einer Mischung mit festen Partikeln, bei dem der Körper Bereiche unterschiedlicher Dichte umfasst.

Die Druckschrift US 2014/0856620 A1 betrifft eine selbstnivellierende Baugruppe, die zur Verwendung mit einem stereolithografischen Drucksystem angepasst ist.

Auf Stereolithografie basierende Techniken sind durch den schichtweisen Aufbau des Materials in physikalischen Eigenschaften limitiert. Durch die im Prozess definierte Maximal-Schichtstärke ist die Verarbeitung von größeren Füllstoffen normalerweise nicht möglich. Gerade diese Füllstoffe sind jedoch in der Lage, die Eigenschaften der verwendeten Materialsysteme grundlegend zu verändern, wie beispielsweise im Bereich der Composite-Materialien. Im Bereich der Zahnmaterialien kann mit Füllstoffen beispielsweise die Abrasionsbeständigkeit erhöht werden. Auch auf die Polierbarkeit oder Verfärbungstendenz der Materialien haben Füllstoffpartikel einen positiven Einfluss.

Eine Verwendung von größeren Füllstoffen kann theoretisch durch eine entsprechende Erhöhung der Schichtstärke auf Kosten der Genauigkeit realisiert werden. Viele Harze zur Stereolithografie sind jedoch überhaupt nicht gefüllt oder enthalten Teilchen mit Größen kleiner als 1 µm als Verdicker, Rheologie-Additive oder Pigmente. Aktuelle Formulierungen für Stereolithografie-Dentalmaterialien weisen keine Füllstoffe mit einem Durchmesser größer als 1 µm auf. Damit wird vor allem versucht die Thematik der Sedimentation von Partikeln in den Harzen zu umgehen.

Gewöhnliche Di(meth)acrylat-basierte Stereolithografie-Harze für die Herstellung von Prothesen enthalten im Allgemeinen keine Füllstoffe. Gelegentlich werden niedrige Anteile an Pigmenten verwendet, die im Prinzip auch als Füllstoffe fungieren können. Mit der Belichtung (DLP, SLA) wird das Material durch Polymerisation in Form gebracht und fixiert, die Polymerisation wird aber dabei nicht vollständig durchgeführt. Dieser Zustand wird auch als "grüner Zustand" bezeichnet.

Eine weitestgehende Beendigung des Prozesses erfolgt im Anschluss in sogenannten Vergütungsverfahren. Diese Verfahren führen die Polymerisation durch eine Bestrahlung und/oder ein Erwärmen so weit wie möglich fort. Dabei erreicht das Material seine endgültigen physikalischen Eigenschaften, wie beispielsweise Elastizitäts-Modul, Biegefestigkeit, Härte, und die endgültige Geometrie. Dabei kommt es aufgrund der Reaktion zu Veränderungen in der Form, wie beispielsweise einer Schrumpfung, oder Spannungen im Material.

Die Verwendung von Füllstoffen zur Verringerung dieser Effekte ist prinzipiell möglich. Füllstoffe mit kleinen Partikeln führen aber oft zu einer starken Verdickung des Systems, beispielsweise Nano-Füllstoffe wie pyrogene Kieselsäure. Füllstoffe mit größeren Partikeln, die diese Verdickung nicht im selben Maß auslösen, können aufgrund der festgesetzten maximalen Schichtstärken beim Bauprozess aber nicht eingesetzt werden. Die meisten Stereolithografie-Geräte arbeiten aktuell mit minimalen Baustärken von 20 µm, bevorzugt 50 µm.

Es ist die technische Aufgabe der Erfindung, die physikalischen Eigenschaften eines Bauteils zu verbessern, dass durch eine Suspension mit Füllstoffpartikeln hergestellt wird.

Gemäß einem ersten Aspekt wird diese technische Aufgabe durch ein Stereolithografieverfahren gelöst, mit den Schritten eines Aufnehmens einer lichthärtenden Suspension mit Füllstoffpartikeln in einer Wanne; eines Einstellens der lichthärtenden Suspension mittels einer Bauplattform auf eine Schichtstärke gegenüber einem Boden der Wanne, der geringer als der Durchmesser der Füllstoffpartikel ist und die Füllstoffpartikel während des Einstellens der ersten und/oder einer weiteren Schichtstärke in den flexiblen Boden der Wanne eindringen; und eines selektiven Aushärtens der eingestellten Schichtstärke der Suspension mittels Licht. Bei dem Stereolithografieverfahren können Füllstoffe mit einem die maximale geplante Bauhöhe überschreitenden maximalen Durchmesser eingesetzt werden. Dadurch wird beispielsweise der technische Vorteil erreicht, dass ein kompakter Aufbau des hergestellten Bauteils erreicht wird.

Durch das Stereolithografieverfahren wird der technische Vorteil erreicht, dass eine strukturelle Veränderung des internen Aufbaus des Werkstücks weg vom geschichteten Anordnungsmuster von Füllstoffen zu willkürlicher Verteilung über die Matrixschichten (aus polymerisiertem Harz) im System hinweg erfolgt. Damit werden verfahrensbedingte anisotrope Eigenschaften verringert und das hergestellte Bauteil verhält sich isotrop. Dies ist im Besonderen bei Zahnmaterialien (analog Konfektionszähnen), aber auch bei Composite-Materialien von großem Vorteil.

In einer technisch vorteilhaften Ausführungsform des Stereolithografieverfahrens ist die Schichtstärke geringer als der Durchmesser von zumindest 5% der Füllstoffpartikel. Dadurch wird beispielsweise der technische Vorteil erreicht, dass die Eigenschaften des hergestellten Bauteils weiter verbessert werden.

In einer weiteren technisch vorteilhaften Ausführungsform des Stereolithografieverfahrens wird für die folgende Schicht die gebaute Schicht vom Boden getrennt. Dadurch wird beispielsweise der technische Vorteil erreicht, dass weitere Schichten auf dieser Schicht aufgebaut werden können.

In einer weiteren technisch vorteilhaften Ausführungsform des Stereolithografieverfahrens wird eine mechanische Spannung einer Folie, die den Boden der Wanne bedeckt, mittels einer Kraftmessung bestimmt. Dadurch wird beispielsweise der technische Vorteil erreicht, dass ein Reißen der Folie verhindert werden kann.

In einer weiteren technisch vorteilhaften Ausführungsform des Stereolithografieverfahrens werden die Füllstoffpartikel während dem ersten Einstellen der Schichtstärke in Aussparungen in einer Druckfläche der Bauplattform aufgenommen. Die Aussparungen können in einem abnehmbaren Austauschteil der Bauplattform gebildet sein. Die Aussparungen können in einem hexagonalen Muster oder einer anderen symmetrischen Geometrie angeordnet sein. Dadurch wird beispielsweise der technische Vorteil erreicht, dass die Anordnung der Füllstoffpartikel vorgegeben werden kann.

In einer weiteren technisch vorteilhaften Ausführungsform des Stereolithografieverfahrens werden die Füllstoffpartikel während dem Einstellen der Schichtstärke in Aussparungen in dem Boden der Wanne oder in einer Referenzebene aufgenommen. Die Aussparungen in können in einem abnehmbaren Austauschteil der Wanne oder der Referenzebene gebildet sein. Die Aussparungen können in einem hexagonalen Muster oder einer anderen symmetrischen Geometrie angeordnet sein. Dadurch wird beispielsweise ebenfalls der technische Vorteil erreicht, dass die Anordnung der Füllstoffpartikel vorgegeben werden kann.

In einer weiteren technisch vorteilhaften Ausführungsform des Stereolithografieverfahren s wird die Wanne und/oder die Bauplattform nach dem Aushärten entlang der Schicht verfahren, um die Füllstoffpartikel in der nächsten Schicht versetzt anzuordnen. Durch das abwechselnde Versetzen in seitlicher Richtung der Bauplattform oder der Wanne wird beispielsweise der technische Vorteil erreicht, dass die Füllstoffpartikel von Schicht zu Schicht versetzt angeordnet werden können und ein homogener Aufbau erreicht wird.

Gemäß einem zweiten Aspekt wird diese technische Aufgabe durch eine Stereolithografievorrichtung zum Durchführen eines Verfahrens mit den Schritten eines Aufnehmens einer lichthärtenden Suspension mit Füllstoffpartikeln in einer Wanne; eines Einstellens der lichthärtenden Suspension mittels einer Bauplattform auf eine Schichtstärke gegenüber einem Boden der Wanne; und eines selektiven Aushärtens der eingestellten Schichtstärke der Suspension mittels Licht, wobei die Bauplattform, der Boden der Wanne oder eine Referenzebene Aussparungen zum Aufnehmen der Füllstoffpartikel umfasst. Durch die Stereolithografievorrichtung werden die gleichen technischen Vorteile wie durch das Stereolithografieverfahren erreicht und dass die Füllstoffpartikel an vorgegebenen Positionen angeordnet werden können.

In einer technisch vorteilhaften Ausführungsform der Stereolithografievorrichtung umfasst die Stereolithografievorrichtung eine Wanne mit einem Boden umfasst, der aus einem Material gebildet ist, in das die Füllstoffpartikel eindringen können. Dadurch wird beispielsweise ebenfalls der technische Vorteil erreicht, dass ein kompakter Aufbau des hergestellten Bauteils erreicht wird.

In einer weiteren technisch vorteilhaften Ausführungsform der Stereolithografievorrichtung umfasst das Material eine transparente, elastische Folie oder eine Silikonschicht. Dadurch wird beispielsweise der technische Vorteil erreicht, dass besonders geeignete Materialien verwendet werden, die ein Eindringen der Füllstoffpartikel erlauben.

In einer weiteren technisch vorteilhaften Ausführungsform der Stereolithografievorrichtung ist der Boden der Wanne austauschbar. Dadurch wird beispielsweise der technische Vorteil erreicht, dass der Boden an die Füllstoffpartikel angepasst werden kann.

Ausführungsbeispiele der Erfindung sind in den Zeichnungen dargestellt und werden im Folgenden näher beschrieben.

Es zeigen:
- Fig. 1A bis 1D: einen schematischen Aufbau einer Stereolithografievorrichtung;
- Fig. 2: eine Querschnittansicht durch unterschiedlich hergestellte Werkstücke;
- Fig. 3A: einen schematischen Aufbau einer weiteren Stereolithografievorrichtung;
- Fig. 3B: eine Aufsicht auf eine strukturierte Bauplattform; und
- Fig. 4: ein Blockdiagramm eines Stereolithografieverfahrens.

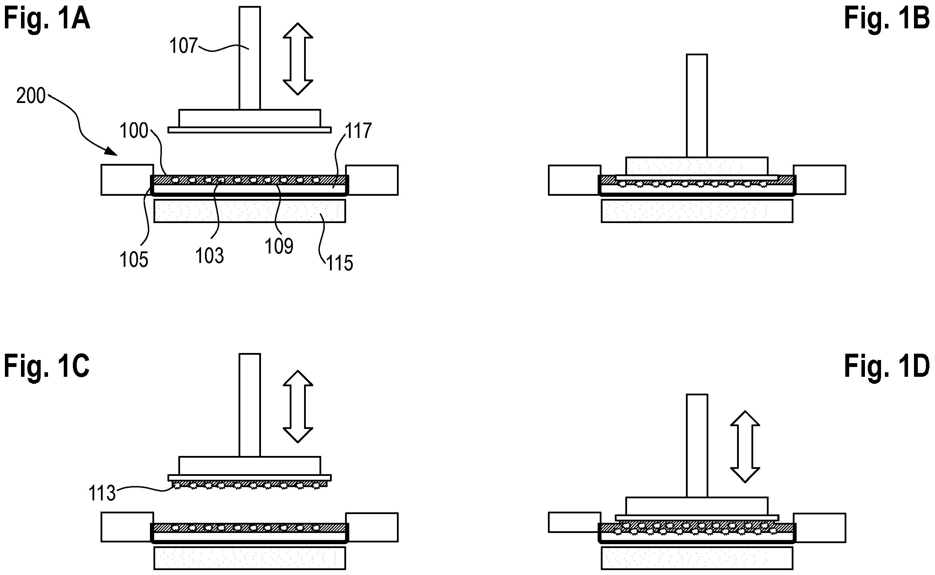

Fig. 1A - 1D zeigen einen schematischen Aufbau einer Stereolithografievorrichtung 200. Die Stereolithografievorrichtung 200 dient zum schichtweisen Herstellen eines Werkstücks oder Bauteils 113. Hierzu wird ein Photopolymer oder ein Monomergemisch einer Suspension 100 mittels Licht schichtweise ausgehärtet. Neben dem Photopolymer umfasst die Suspension 100 Füllstoffpartikel 103. Die Füllstoffpartikel 103 sind nach dem Aushärten in der Polymermatrix eingebettet. Durch die Füllstoffpartikel 103 wird die Festigkeit und Abrasionsbeständigkeit erhöht. Zudem können die Füllstoffpartikel 103 die Polierbarkeit des Werkstücks 113 verbessern oder eine Neigung zur Verfärbung verringern.

Die Füllstoffpartikel 103 liegen beispielsweise mit einem durchschnittlichen Durchmesser von 30 µm bis 80 µm vor. Diese Füllstoffe können beispielsweise durch Metalloxid-Partikel, wie Aluminiumoxid-Partikel, Kieselsäure-Partikel, keramische Partikel, Partikel aus vernetzten Polymeren, Composite-Partikel, Glas-Partikel, Duromer-Partikel oder Polymerpartikel gebildet sein.

In Fig. 1A befindet sich die lichthärtende Suspension 100 (Harz) mit den Füllstoffpartikeln 103 in einer Wanne 105 der Stereolithografievorrichtung 200. Die Bauplattform 107 befindet sich in einem zurückgefahrenen Zustand. Die Füllstoffpartikel 103 sind zufällig in der Suspension 100 verteilt.

Die Wanne 105 weist einen durchsichtigen Boden 109 auf, so dass die Suspension 100 durch den Boden 109 der Wanne 105 hindurch mit Licht bestrahlt werden kann, um das Polymer auszuhärten. Unterhalb des Bodens 109 befindet sich zu diesem Zweck eine Belichtungssteuerung 115, die unterschiedliche Lichtmuster erzeugen kann. Durch die Belichtungssteuerung 115 lässt sich das Polymer in einem gewünschten Umriss und einer Fläche selektiv schichtweise aushärten. Dadurch kann jede einzelne Schicht in einer beliebig vorgebbaren Fläche ausgebildet werden.

In Fig. 1B wird der Bauprozess initiiert. Dabei wird durch die Bauplattform 107 die gewünschte Schichtstärke zur Ausformung der ersten Schicht angefahren. Die Schicht bildet sich zwischen dem Boden 109 der Wanne 105 und der ebenen Unterseite der Bauplattform 107 aus. Die minimale Schichtstärke ist geringer als der Durchmesser der Füllstoffpartikel 103. Die Füllstoffpartikel 103 dringen vollständig oder teilweise in den Boden 109 der Wanne 105 ein.

Zu diesem Zweck kann die Wanne 105 kann eine elastische Folie 117 aufweisen, die durch die Füllstoffpartikel 103 verformt wird. Anschließend erfolgt die selektive Belichtung, wie beispielsweise durch ein Lichtmuster, der eingestellten Schichtstärke durch die Belichtungssteuerung 115, so dass diese an den beleuchteten Stellen aushärtet. Durch den Druck, den die Bauplattform 107 auf die Füllstoffpartikel 103 ausübt, dringen diese in den Boden 109 der Wanne 105 ein. Durch die Belichtungssteuerung 115 wird dieser Zustand fixiert.

Der Boden 109 der Wanne 105 kann austauschbar sein. Der Boden 109 kann auch eine elastische Folie 117 aufweisen, die den Boden 109 der Wanne 105 bedeckt und in die die Füllstoffpartikel 103 gedrückt werden. Die mechanische Spannung der Folie 117 kann mittels einer mittels einer Kraftmessvorrichtung bestimmt werden. In diesem Fall kann die Bauplattform 107 nur solange verfahren werden, bis die mechanische Spannung der Folie 117 einen vorgegebenen Wert nicht überschreitet. Zudem kann ein Reißen der Folie 117 verhindert werden.

Der Boden 109 der Wanne 105 kann auf einer Glaspatte aufliegen, die eine separate Referenzebene bildet. Der Glasboden stützt dabei den Boden der 109 Wanne 105 von unten. Wird eine Folie 117 oder eine Wanne 105 mit Silikonschicht verwendet, kann die Glasplatte bei einem Reißen der Folie 117 oder der Silikonschicht verhindern, dass die Suspension 100 ausläuft.

In Fig. 1C wird die Bauplattform 107 erneut zurückgefahren. Für die folgende Schicht wird die gebaute Schicht vom Boden 109 getrennt. Die Füllstoffpartikel 103 stehen aus der Ebene der polymerisierten Harzmatrix heraus, die sich an der Bauplattform 107 befindet und bilden eine raue Oberflächenstruktur. Der Pegel der Suspension 100 gleicht sich in der Wanne 105 aus. Danach ist Stereolithografievorrichtung 200 bereit für den nächsten Schichtaufbau. Im Stereolithografie-Prozess wird die Bauplattform 107 nicht vollständig aus der Wanne 105 herausgefahren. Der Inhalt der Wanne 105 umfasst normalerweise einige mm an Höhe, so dass die Suspension 100 nach einem geringen Anheben der Bauplattform 107 wieder nachfließt.

In Fig. 1D wird der Bauprozess fortgesetzt, indem erneut die gewünschte Schichtstärke durch die Bauplattform 107 angefahren wird. Die Schichtstärke wird in diesem Fall zwischen der bereits ausgehärteten Sicht und dem Boden 109 der Wanne 105 eingestellt. Hierdurch dringen auch die Füllstoffpartikel 103 der neuen Schicht in den Boden 109 der Wanne 105 ein. Da die Füllstoffpartikel 103 der neuen Schicht den Erhebungen der Füllstoffpartikel 103 der bereits ausgehärteten Schicht ausweichen, ergibt sich eine schichtweise versetzte Anordnung der Füllstoffpartikel 103.

Danach erfolgt eine weitere Belichtung, so dass auch diese Schicht aushärtet. Die Füllstoffpartikel 103 der neuen Schicht füllen die Lücken zwischen den Füllstoffpartikel 103 der vorherigen Schicht. Dieser Prozess des Schichtaufbaus wird solange wiederholt, bis die gewünschte Bauhöhe des Werkstücks 113 erreicht ist.

Die mit dem Stereolithografieverfahren produzierbaren Werkstücke 113 besitzen eine innere Füllstoffverteilung, die der von Bulkprozessen ähnlich ist, wie beispielsweise beim Spritzguss oder bei gefrästen Körpern aus Rohlingen. Die Abrasionsfestigkeit und andere physikalische Eigenschaften nähern sich dem Idealzustand an, da keine parallelen, füllstofffreien Matrixschichten mehr vorliegen. Die Orientierung beim Bau spielt nur noch eine untergeordnete Rolle. Die einzelnen Schichten sind parallel und können auch nur wenige Füllstoffpartikel 103 umfassen, die in die nächste Schicht ragen.

Das additiv hergestellte Werkstück 113 kann mit den schichtenübergreifenden Füllstoffen auf völlig neue physikalische Eigenschaften eingestellt werden. Im Falle von Dentalmaterialien, wie beispielsweise Zahnmaterial oder Composite-Materialien, können Materialien realisiert werden, deren Eigenschaften deutlich näher an konventionell hergestellten Zahn-, Prothesen- oder Composite-Materialien ist. Durch die Verwendung von Füllstoffen können Glanzstabilität, Abrasionsfestigkeit oder physikalische Eigenschaften, wie Biegefestigkeit oder Schlagzähigkeit, optimiert werden. Zudem können schlecht oder wenig verformbare (Hart)-Gummitypen zur Schlagzähmodifizierung für ein Prothesenbasismaterial verwendet werden.

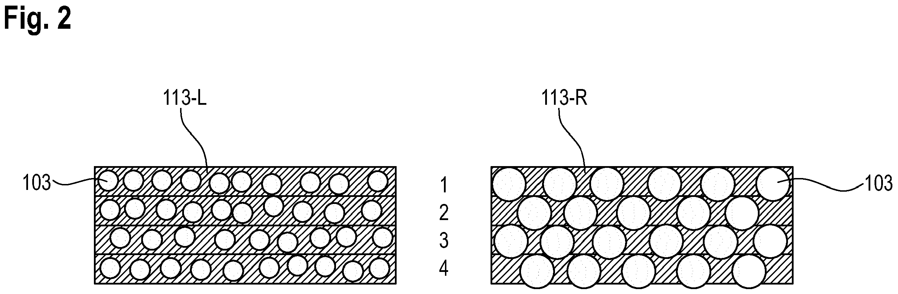

Fig. 2 zeigt eine Querschnittansicht durch unterschiedlich hergestellte Werkstücke 113-L und 113-R mit den Schichten 1 bis 4. Das linke Werkstück 113-L ist mit einem herkömmlichen Stereolithografieverfahren hergestellt worden. In diesem Werkstück 113-L sind die Füllstoffpartikel 103 in parallelen Schichten angeordnet, die von füllstofffreien Zwischenschichten getrennt werden. Durch die Konzentration der Füllstoffpartikel 103 auf die Schichten entsteht ein ungleichmäßiger Aufbau des Werkstücks 113-L.

Das rechte Werkstück 113-R ist hingegen mit dem neuen Stereolithografieverfahren hergestellt worden. In diesem Werkstück 113-R verteilen sich die Füllstoffpartikel 103 gleichmäßig und strukturiert über das ganze Volumen hinweg, ohne dass diese von füllstofffreien Zwischenschichten getrennt sind. Dies wird dadurch erreicht, dass diese während dem Aushärten teilweise aus ihrer ursprünglichen Schicht herausgedrückt werden. Beim Aufbau der nächsten Schicht ragen diese dann teilweise in diesen hinein. Obwohl die Füllstoffpartikel 103 als einheitlich groß dargestellt sind, können diese eine Größenverteilung aufweisen.

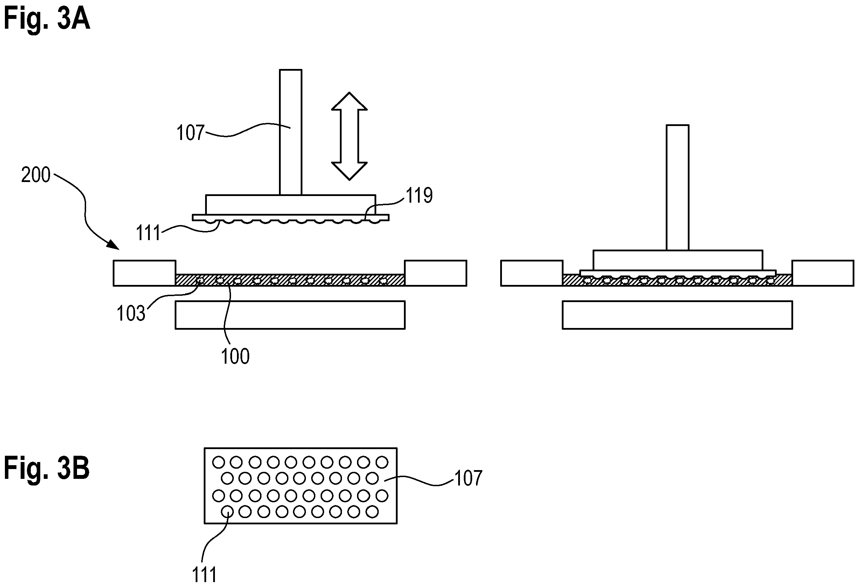

Fig. 3A zeigt einen schematischen Aufbau einer weiteren Stereolithografievorrichtung 200. In dieser Stereolithografievorrichtung 200 umfasst die Bauplattform 107 an deren Druckfläche 119 Aussparungen 111, in denen die Füllstoffpartikel 103 während dem ersten Einstellen der Schichtstärke teilweise aufgenommen werden können. Die Bauplattform 107 kann auch Erhebungen umfassen, denen die Füllstoffpartikel 103 beim Einstellen der Schichtstärke ausweichen müssen.

Die strukturierte Bauplattform 107 fährt auf den korrekten Abstand zur Ausformung der ersten Schicht. Die Füllstoffpartikel 103 weichen der Strukturierung auf der Bauplattform 107 aus und Formen ein Anordnungsschema für die erste Schicht. Die Füllstoffpartikel 103 können anschließend in den Boden 109 der Wanne 105 einsinken oder nicht.

Fig. 3B zeigt eine Aufsicht auf eine strukturierte Bauplattform 107. Die Aussparungen oder Erhebungen 111 sind in der Druckfläche 119 der Bauplattform 107 gebildet. Die Aussparungen oder Erhebungen 111 können in einem hexagonalen Muster oder einer anderen symmetrischen Geometrie in der Bauplattform 107 angeordnet sein. Dadurch können die Füllstoffpartikel 103 an gewünschten Stellen angeordnet werden.

Die Funktionalität des Stereolithografieverfahrens hängt von der Füllstoffverteilung in der ersten erstellten Schicht ab, da die Positionen der Füllstoffpartikel 103 die jeweiligen in der nächsten Schicht vorgeben. Die Füllstoffverteilung in der ersten gebauten Schicht erfolgt willkürlich durch schwer vorhersehbare physikalische Prozesse, wie beispielsweise aufgrund einer Rheologie.

Durch die strukturierte Bauplattform 107 wird für die erste Schicht eine Vorgabe zur räumlichen Verteilung der übermaßigen Füllstoffpartikel zu schaffen. Damit wird verhindert, dass sich die Partikel in der ersten Schicht willkürlich anordnen und sich dieses Muster in den folgenden Schichten durch jeweiliges Ausweichen in die Lücken, fortsetzt.

Die strukturierte Bauplattform 107 gibt eine klare Struktur vor, um die gewünschte Materialeigenschaft des Werkstücks einstellen zu können. Hierzu ein Adapter oder ein Aufsetzteil für die strukturierte Bauplattform 107 mit unterschiedlich angeordneten Aussparungen oder Erhebungen 111 denkbar, der für die unterschiedlichen Füllkörperdimensionen die Struktur vorgibt.

Allerdings können die Erhebungen oder Aussparungen 111 zum Positionieren der Füllstoffpartikel 103 auch im Boden 109 der Wanne 105 oder in einer Referenzebene gebildet sein.

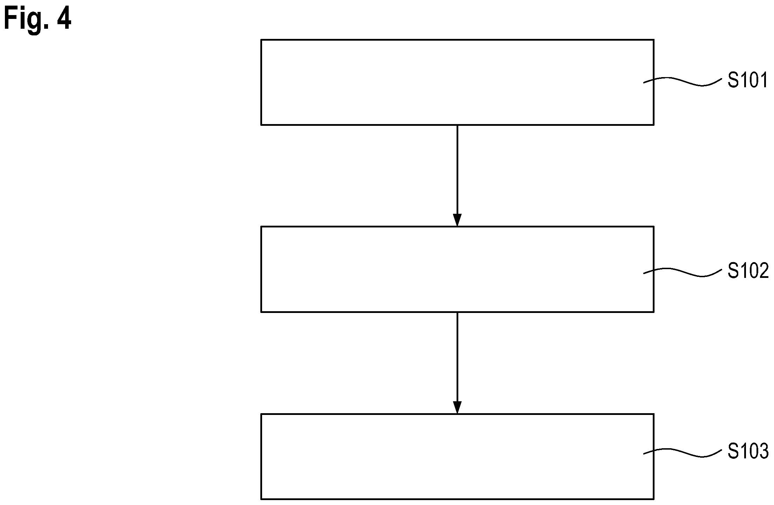

Fig. 4 zeigt ein Blockdiagramm eines Stereolithografieverfahrens. Im ersten Schritt S101 wird eine lichthärtende Suspension 100 mit Füllstoffpartikeln 103 in der Wanne 105 aufgenommen. Anschließend wird in Schritt S102 die lichthärtende Suspension mittels einer Bauplattform 107 auf eine Schichtstärke gegenüber einem Boden 109 der Wanne 105 eingestellt, der geringer als der Durchmesser der Füllstoffpartikel 103 ist. In Schritt S103 wird die eingestellte Schichtstärke der Suspension mittels Licht ausgehärtet. Anschließend wird die Bauplattform 107 angehoben, so dass sich die die ausgehärtete Schicht von dem Boden der Wanne 105 trennt und die Schritte S102 und 103 werden wiederholt.

Bei einer Wiederholung der Schritte kann die Wanne 105 und/oder die Bauplattform 107 nach dem Aushärten entlang der Schicht abwechselnd seitlich, d.h. nach links oder rechts gegenüber der Wanne 105, verfahren werden, um die Füllstoffpartikel 103 in der nächsten Schicht versetzt anzuordnen. Dadurch kann eine Homogenität des Aufbaus des Werkstücks 113 verbessert werden. Statt der Bauplattform 107 kann auch die Wanne 107 abwechselnd in seitlicher Richtung gegenüber der Bauplattform 107 verfahren werden. Dadurch lässt sich ebenfalls ein homogener Aufbau des Werkstücks 113 erreicht werden.

Alle in Verbindung mit einzelnen Ausführungsformen der Erfindung erläuterten und gezeigten Merkmale können in unterschiedlicher Kombination in dem erfindungsgemäßen Gegenstand vorgesehen sein, um gleichzeitig deren vorteilhafte Wirkungen zu realisieren.

Alle Verfahrensschritte können durch Vorrichtungen implementiert werden, die zum Ausführen des jeweiligen Verfahrensschrittes geeignet sind. Alle Funktionen, die von gegenständlichen Merkmalen ausgeführt werden, können ein Verfahrensschritt eines Verfahrens sein.

Der Schutzbereich der vorliegenden Erfindung ist durch die Ansprüche gegeben und wird durch die in der Beschreibung erläuterten oder den Figuren gezeigten Merkmale nicht beschränkt.

### BEZUGSZEICHENLISTE

- 100: Suspension
- 103: Füllstoffpartikel
- 105: Wanne
- 107: Bauplattform
- 109: Boden
- 111: Aussparung
- 113: Werkstück
- 115: Belichtungssteuerung
- 117: Folie
- 119: Druckfläche
- 200: Stereolithografievorrichtung

## Patentansprüche

1. Stereolithografieverfahren, mit den Schritten:
- Aufnehmen (S101) einer lichthärtenden Suspension (100) mit Füllstoffpartikeln (103) in einer Wanne (105);
- Einstellen (S102) der lichthärtenden Suspension mittels einer Bauplattform (107) auf eine Schichtstärke gegenüber einem Boden (109) der Wanne (105), der geringer als der Durchmesser der Füllstoffpartikel (103) ist; und die Füllstoffpartikel (103) während des Einstellens der ersten und/oder einer weiteren Schichtstärke in den flexiblen Boden (109) der Wanne (105) eindringen; und
- selektives Aushärten (S103) der eingestellten Schichtstärke der Suspension mittels Licht.

2. Stereolithografieverfahren nach Anspruch 1, wobei die Schichtstärke geringer als der Durchmesser von zumindest 5% der Füllstoffpartikel (103) ist.

3. Stereolithografieverfahren nach Anspruch 1 oder 2, wobei für die folgende Schicht die gebaute Schicht vom Boden (109) getrennt wird.

4. Stereolithografieverfahren nach einem der vorangehenden Ansprüche, wobei eine mechanische Spannung einer Folie (117), die den Boden (109) der Wanne (105) bedeckt, mittels einer Kraftmessung bestimmt wird.

5. Stereolithografieverfahren nach einem der vorangehenden Ansprüche, wobei die Füllstoffpartikel (103) während dem ersten Einstellen der Schichtstärke in Aussparungen (111) in einer Druckfläche (119) der Bauplattform (107) aufgenommen werden.

6. Stereolithografieverfahren nach einem der vorangehenden Ansprüche, wobei die Füllstoffpartikel (103) während dem Einstellen der Schichtstärke in Aussparungen (111) in dem Boden (109) der Wanne (105) oder in einer Referenzebene (110) aufgenommen werden.

7. Stereolithografieverfahren nach einem der vorangehenden Ansprüche, wobei die Wanne (105) und/oder die Bauplattform (107) nach dem Aushärten entlang der Schicht verfahren wird, um die Füllstoffpartikel in der nächsten Schicht versetzt anzuordnen.

8. Stereolithografievorrichtung (200) zum Durchführen eines Verfahrens mit den Schritten eines Aufnehmens (S101) einer lichthärtenden Suspension (100) mit Füllstoffpartikeln (103) in einer Wanne (105); eines Einstellens (S102) der lichthärtenden Suspension mittels einer Bauplattform (107) auf eine Schichtstärke gegenüber einem Boden (109) der Wanne (105); und eines selektiven Aushärtens (S103) der eingestellten Schichtstärke der Suspension mittels Licht, wobei die Bauplattform (107), der Boden (109) der Wanne (105) oder die Referenzebene (110) Aussparungen (111) zum Aufnehmen der Füllstoffpartikel (103) umfasst.

9. Stereolithografievorrichtung (200) nach Anspruch 8, wobei die Stereolithografievorrichtung (200) eine Wanne (105) mit einem Boden (109) umfasst, der aus einem Material gebildet ist, in das die Füllstoffpartikel (103) eindringen können.

10. Stereolithografievorrichtung (200) nach Anspruch 9, wobei das Material eine transparente, elastische Folie (117) oder eine Silikonschicht umfasst.

11. Stereolithografievorrichtung (200) nach Anspruch 10, wobei der Boden (109) der Wanne (105) austauschbar ist.

## Claims

1. Stereolithography method, comprising the steps of:
- receiving (S101) a light-curing suspension (100) with filler particles (103) in a tray (105);
- adjusting (S102) the light-curing suspension by means of a build platform (107) to a layer thickness with respect to a bottom (109) of the tray (105) which is less than the diameter of the filler particles (103); and the filler particles (103) penetrate into the flexible bottom (109) of the tray (105) during the adjustment of the first and/or a further layer thickness; and
- selectively curing (S103) the adjusted layer thickness of the suspension by means of light.

2. Stereolithography method according to claim 1, wherein the layer thickness is less than the diameter of at least 5% of the filler particles (103).

3. Stereolithography method according to claim 1 or 2, wherein for the following layer the built layer is separated from the bottom (109).

4. Stereolithography method according to any one of the preceding claims, wherein a mechanical stress of a film (117) covering the bottom (109) of the tray (105) is determined by means of a force measurement.

5. Stereolithography method according to any one of the preceding claims, wherein the filler particles (103) are received in recesses (111) in a printing surface (119) of the build platform (107) during the first adjustment of the layer thickness.

6. Stereolithography method according to any one of the preceding claims, wherein the filler particles (103) are received in recesses (111) in the bottom (109) of the tray (105) or in a reference plane (110) during the adjustment of the layer thickness.

7. Stereolithography process according to any one of the preceding claims, wherein the tray (105) and/or the build platform (107) is moved along the layer after curing to offset the filler particles in the next layer.

8. A stereolithography apparatus (200) for performing a method comprising the steps of receiving (S101) a light-curing suspension (100) comprising filler particles (103) in a well (105); adjusting (S102) the light-curing suspension by means of a build platform (107) to a layer thickness relative to a bottom (109) of the tray (105); and selectively curing (S103) the adjusted layer thickness of the suspension by means of light, wherein the build platform (107), the bottom (109) of the tray (105) or the reference plane (110) comprises recesses (111) for receiving the filler particles (103).

9. Stereolithography apparatus (200) according to claim 8, wherein the stereolithography apparatus (200) comprises a tray (105) having a bottom (109) formed of a material into which the filler particles (103) can penetrate.

10. Stereolithography apparatus (200) according to claim 9, wherein said material comprises a transparent elastic film (117) or a silicone layer.

11. Stereolithography apparatus (200) according to claim 10, wherein the bottom (109) of the tray (105) is replaceable.

## Revendications

1. Procédé de stéréolithographie, comprenant les étapes suivantes :
- recevoir (S101) d'une suspension photodurcissable (100) avec des particules de charge (103) dans une cuve (105);
- ajuster (S102) de la suspension photodurcissable au moyen d'une plate-forme de construction (107) à une épaisseur de couche par rapport à un fond (109) de la cuve (105) qui est inférieure au diamètre des particules de charge (103); et les particules de charge (103) pénètrent dans le fond flexible (109) de la cuve (105) pendant l' ajustement de la première et/ou d'une autre épaisseur de couche; et
- durcir sélectif (S103) de l'épaisseur de couche ajustée de la suspension au moyen de lumière.

2. Procédé de stéréolithographie selon la revendication 1, dans lequel l'épaisseur de couche est inférieure au diamètre d'au moins 5% des particules de charge (103).

3. Procédé de stéréolithographie selon la revendication 1 ou 2, dans lequel, pour la couche suivante, la couche construite est séparée du fond (109).

4. Procédé de stéréolithographie selon l'une des revendications précédentes, dans lequel une tension mécanique d'un film (117) recouvrant le fond (109) de la cuve (105) est déterminée par une mesure de force.

5. Procédé de stéréolithographie selon l'une quelconque des revendications précédentes, dans lequel les particules de charge (103) sont reçues dans des évidements (111) dans une surface d'impression (119) de la plateforme de construction (107) pendant le premier réglage de l'épaisseur de couche.

6. Procédé de stéréolithographie selon l'une des revendications précédentes, dans lequel les particules de charge (103) sont reçues dans des évidements (111) dans le fond (109) du cuve (105) ou dans un plan de référence (110) pendant le réglage de l'épaisseur de couche.

7. Procédé de stéréolithographie selon l'une quelconque des revendications précédentes, dans lequel le cuve (105) et/ou la plate-forme de construction (107) est déplacée le long de la couche après le durcissement afin de disposer les particules de charge de manière décalée dans la couche suivante.

8. Dispositif de stéréolithographie (200) pour la mise en oeuvre d'un procédé comprenant les étapes de réception (S101) d'une suspension photodurcissable (100) avec des particules de charge (103) dans un cuve (105) ; d'ajustement (S102) de la suspension photodurcissable au moyen d'une plate-forme de construction (107) à une épaisseur de couche par rapport à un fond (109) du cuve (105) ; et d'un durcissement sélectif (S103) de l'épaisseur de couche ajustée de la suspension au moyen de lumière, la plate-forme de construction (107), le fond (109) de la cuve (105) ou le plan de référence (110) comprenant des évidements (111) pour recevoir les particules de charge (103).

9. Dispositif de stéréolithographie (200) selon la revendication 8, dans lequel le dispositif de stéréolithographie (200) comprend une cuve (105) ayant un fond (109) formé d'un matériau dans lequel les particules de charge (103) peuvent pénétrer.

10. Dispositif de stéréolithographie (200) selon la revendication 9, dans lequel le matériau comprend un film élastique transparent (117) ou une couche de silicone.

11. Dispositif de stéréolithographie (200) selon la revendication 10, dans lequel le fond (109) de la cuve (105) est interchangeable.
